# EUROPEAN PATENT APPLICATION

(11) **EP 4 553 449 A1**
(43) Date of publication of application: **14.05.2025**
(21) Application number: 24207769.1
(22) Date of filing: 21.10.2024
(51) Int. Cl.: G01C 19/5733, B81B 3/00, G01C 19/5769

(54) **MICROELECTROMECHANICAL DEVICE WITH MOVABLE MASS AND STOPPING STRUCTURE HAVING IMPROVED MECHANICAL ROBUSTNESS**

(30) Priority: 07.11.2023 IT 202300023379
(71) Applicant: STMicroelectronics International N.V., 1228 Plan-les-Ouates, Geneva (CH)
(72) Inventor: GATTERE, Gabriele, 21040 CASTRONNO (VA) (IT); RIANI, Manuel, 22100 COMO (IT)
(74) Representative: Studio Torta S.p.A.

(57) **Abstract**

A microelectromechanical device (1) includes: a supporting body (2), containing semiconductor material; a movable mass (3), constrained to the supporting body (2) with a relative degree of freedom with respect to a first motion direction (D1) perpendicular to the supporting body (2); and at least one stopping structure (5), configured to limit out-of-plane movements of the movable mass (3) along the first motion direction (D1). The stopping structure (5) includes: first elements (6), extending parallel to the first motion direction (D1) and anchoring the stopping structure (5) to the supporting body (2); and a second element (7), extending transversally to the first elements (6), surmounting and connecting the first elements (6).

## Description

### Technical Field

The present invention relates to a microelectromechanical (MEMS) device with movable mass and stopping structure having improved mechanical robustness.

### Background

Inertial micro-electro-mechanical (MEMS) devices, such as for example gyroscopes and accelerometers, base their operation on masses coupled to a supporting body (for example, a frame or a substrate of semiconductor material), through flexures which allow masses to oscillate along one or more directions, with the aim of detecting variations in a physical quantity or functioning as actuators. These masses are commonly defined "movable", or "suspended" masses, and are also formed by a semiconductor material, typically for example by polycrystalline or monocrystalline silicon.

In response to shocks that may occur during the life of the sensors, the movable masses may exceed the range of work positions considered safe. To avoid damage, for example to the springs, stopping elements (also known as "stoppers") are provided which are capable of limiting the displacements allowed by the movable masses. The stopping elements may, for example, act by limiting "in-plane" movements and/or "out-of-plane" movements of the movable masses.

A typical implementation of a stopper that limits "out-of-plane" movements (known as a "Z-stopper") is based on a design comprising a cantilever element (known as "cantilever" design), such as a protruding arm, which extends, starting from an anchor constrained to the supporting body, above - at a distance from - the movable mass. In the manufacturing of a stopper of this type, stringent process requirements in the definition of the cantilever element may give rise, locally, to sharp edges where intense mechanical stresses may be localized, possibly resulting in a decrease in the overall mechanical robustness and breakdowns of the same stoppers following, for example, shocks and falls of the MEMS device.

### Summary

It is therefore an aim of the present invention to overcome or at least partially mitigate the disadvantages and limitations of the state of the art.

According to the present invention, a microelectromechanical device with a movable mass and stopping structure is provided as defined in the attached claims.

### Brief Description of the Figures

For a better understanding of the present invention, preferred embodiments are provided, by way of non-limiting example, with reference to the attached drawings, wherein:
- Figure 1 schematically shows in a cross-section a portion of a MEMS device in accordance with an embodiment of the present invention;
- Figure 2 schematically shows, in a top-plan view, a portion of the MEMS device of Figure 1;
- Figures 3a-3g schematically show consecutive steps of a manufacturing process of the MEMS device of Figure 1;
- Figure 4 schematically shows in a cross-section a portion of a MEMS device in accordance with a different embodiment of the present invention;
- Figure 5 schematically shows, in a top-plan view, a portion of the MEMS device of Figure 4;
- Figure 6 schematically shows, in a cross-section a portion of a MEMS device in accordance with a further embodiment of the present invention; and
- Figure 7 schematically shows, in a top-plan view, a portion of the MEMS device of Figure 6.

### Description of Embodiments

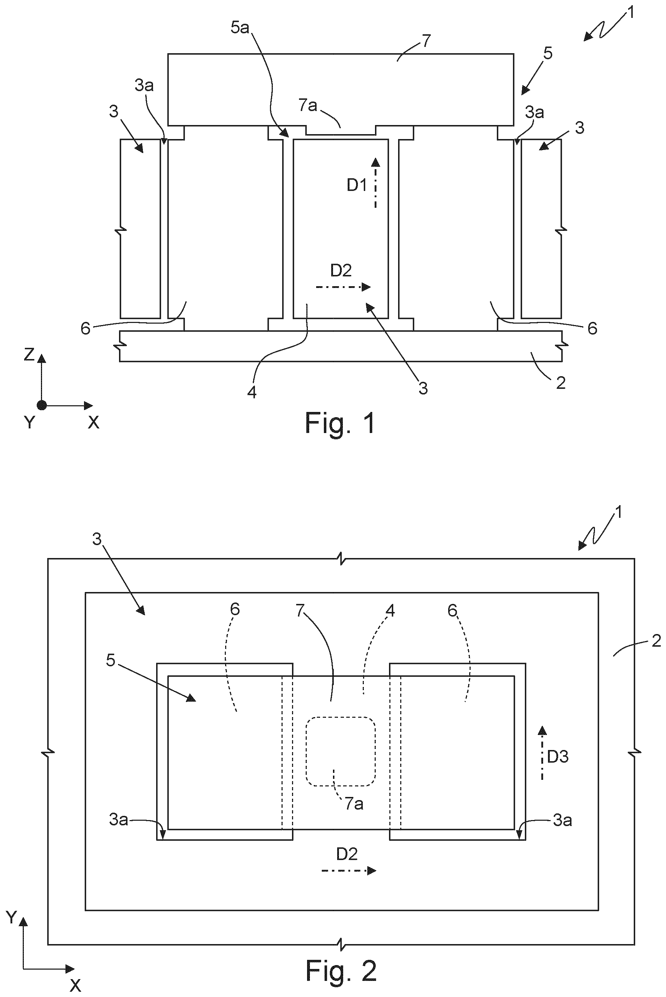

Figure 1 illustrates a portion of a microelectromechanical, or MEMS, device 1 in accordance with one embodiment of the present invention, for example, an inertial sensor, such as an accelerometer or a gyroscope. The MEMS device 1 comprises a supporting body 2, for example a substrate of semiconductor material, and a movable mass 3, also of semiconductor material. The movable mass 3 is coupled to the supporting body 2 so as to be capable of oscillating along one or more motion directions.

In detail, the movable mass 3 is suspended with respect to the supporting body 2, for example by a system comprising fixed anchors and flexures (not shown for simplicity), configured so that the oscillations of the movable mass 3 may occur at least along a first motion direction D1 - perpendicular to the supporting body 2 - and, optionally in case of multi-axial devices, along a second motion direction D2 and a third motion direction D3, orthogonal to each other and both transversal to the first motion direction D1. The oscillations along the first motion direction are of the so-called "out-of-plane" type, while the oscillations along the second motion direction D2 and/or the third motion direction D3 are of the so-called "in-plane" type (reference be made also to Figure 2). Considering a reference system of orthogonal axes X, Y, Z, in one embodiment the first, the second, and the third motion directions D1, D2, D3 are for example drive and detection directions and are respectively parallel to the Z axis, the X axis, and the Y axis. The MEMS device 1 is capable, therefore, of detecting or actuating triaxial displacements and is shown in Figure 1 in a rest condition, i.e. when the movable mass 3 is stationary in absence of external stresses. The movable mass 3 extends, in particular, in a plane parallel to the XY plane and has a height along the Z axis.

The MEMS device 1 further comprises a stopping structure 5, of semiconductor material, coupled to the supporting body 2 and configured to limit the movements of the movable mass 3 along the first motion direction D1 and, in the embodiment of Figures 1 and 2, also along the second and the third motion directions D2, D3 within respective safety intervals. In detail, the stopping structure 5 comprises a pair of anchor blocks 6, identical to and facing each other, and a connection element 7 which bridge-connects the anchor blocks 6 to each other, being in structural continuity therewith.

Referring to Figures 1 and 2, the anchor blocks 6 have a dimension in planes parallel to the XY plane and extend along the Z axis, starting from the supporting body 2, for a distance greater than the maximum height of the movable mass 3. The anchor blocks 6 of the MEMS device 1 therefore anchor the stopping structure 5 to the supporting body 2. The connection element 7 extends transversely to the pair of anchor blocks 6 along the X axis, surmounting and connecting the anchor blocks 6. In particular, the connection element 7 of Figures 1 and 2 has a dimension in planes parallel to the XY plane such as to entirely overlay the anchor blocks 6.

The movable mass 3 of the MEMS device 1 has a pair of through openings 3a (parallel to the Z axis) which have a respective "in-plane" dimension, i.e. parallel to the XY plane (identical to each other in Figure 2). The movable mass 3 further comprises a stopping portion 4 interposed between the openings 3a of a respective pair.

Each opening 3a of the movable mass 3 accommodates a respective anchor block 6 of the stopping structure 5. The anchor blocks 6 are therefore each defined inside a respective opening 3a of the movable mass 3, are separated by the stopping portion 4 and limit the movements of the movable mass 3 along the second and the third motion directions D2, D3, defining the respective safety intervals. The dimension of the openings 3a of the movable mass 3 is a design parameter of the MEMS device 1 with respect to the "in-plane" stopping function to be implemented and, for example, in Figure 2 the profiles of the openings 3a are geometrically similar to the profiles, in section, of the respective anchor blocks 6.

The pair of anchor blocks 6 and the connection element 7 of the stopping structure 5 delimit a through cavity 5a (parallel to the Y axis) and the stopping portion 4 of the movable mass 3 engages the cavity 5a. In particular, the connection element 7 of the stopping structure 5 delimits the cavity 5a on a side opposite to the supporting body 2 and the stopping portion 4 lies below the connection element 7.

The connection element 7 limits the movements of the movable mass 3 along the first motion direction D1, defining the respective safety interval. The distance of the connection element 7 from the stopping portion 4 of the movable mass 3 (at rest), and therefore the height of the anchor blocks 6 with respect to the supporting body 2, is a design parameter of the MEMS device 1 with respect to the "out-of-plane" stopping function to be implemented. For example, the connection element 7 of the stopping structure 5 of the MEMS device 1 comprises a bump 7a which protrudes into the cavity 5a and has a shape selected as a function of the desired displacement limitation along the first motion direction D1.

Hereinafter, the stopping structure 5 of the MEMS device 1 will also be referred to as a "tunnel"-type stopping structure. The tunnel shape of the stopping structure allows the stopping forces caused by the movable mass to be distributed more uniformly on the anchor blocks, while reducing deformations of the stopping structure with respect to a cantilevered condition. The Applicant has verified that it is thus possible to obtain an increase in the overall stiffness of the MEMS device and in particular an increase in the mechanical robustness of the stopping structure, with reductions in the deformation, in use, of the stopping structure up to ten times and with reductions in the localized stress (in terms of Galileo-Rankine stress) down to six times with respect to solutions comprising cantilever elements. Furthermore, as previously observed, the range of allowed displacements of the movable mass may be adjusted and limited in a deterministic and flexible manner by carefully designing the shape and dimensions of the connection element. Ultimately, the stopping structure of the present invention has an increased probability of passing the mechanical qualification tests, typical of consumer electronics, and more generally an improved performance reliability.

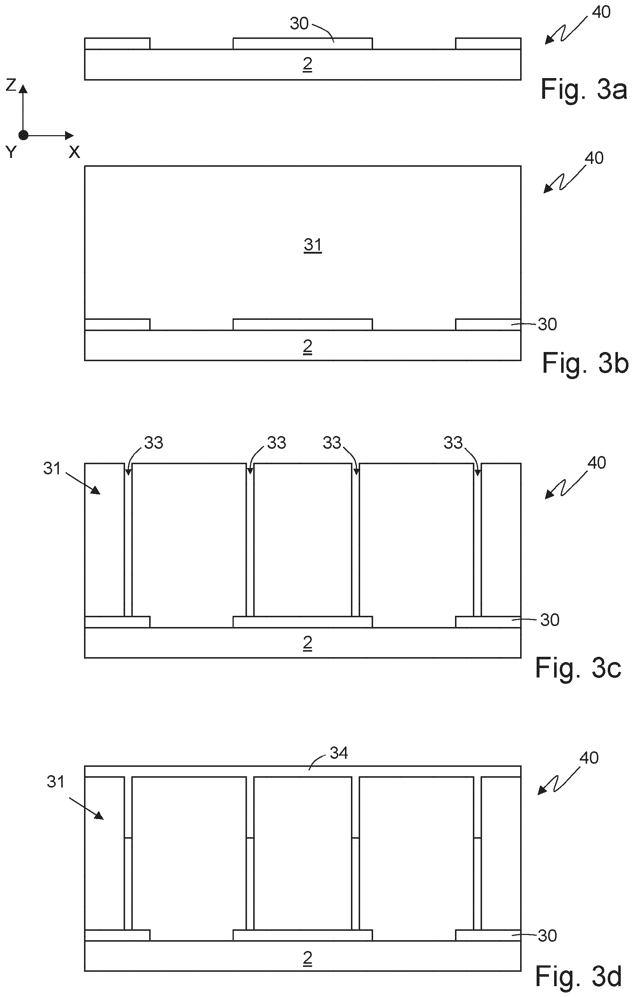

The MEMS device 1 described may be obtained by a manufacturing process whose consecutive steps are generically shown in Figures 3a-3g. In detail, the movable mass 3, the anchor blocks 6 of the stopping structure 5 and the connection element 7 of the stopping structure 5 are formed starting from two structural layers grown on top of each other using an epitaxial reactor (first and second structural layers 31, 32).

In detail, Figure 3a shows a work wafer 40 comprising the supporting body 2 of the MEMS device 1 and a first sacrificial layer 30, for example of silicon oxide, thermally grown or deposited on the supporting body 2. The supporting body 2 may be for example a multilayer comprising a substrate of semiconductor material, a dielectric layer and a conductive structure comprising, for example, fixed electrodes and/or buried electrical connections (not shown separated in the attached Figures). The first sacrificial layer 30 is shown already patterned in order to subsequently form the lower structures of the MEMS device 1, such as for example anchor regions to the supporting body 2.

The first structural layer 31, for example of silicon, is formed (Figure 3b) above and in contact with the first sacrificial layer 30 and with the supporting body 2 in an epitaxial reactor starting from a seed layer not shown for simplicity. The first structural layer 31 has a thickness along the Z axis - comprised for example between 10µm and 30pm - linked to the desired height of the microelectromechanical structures, here for example of the movable mass 3. The first structural layer 31 is then patterned (Figure 3c), for example by dry etching, thus forming trenches 33. Following the etching, which automatically stops at the first sacrificial layer 30, the anchor blocks 6 are defined in contact with the supporting body 2 and the movable mass 3, which is instead separated from the supporting body 2 by portions of the first sacrificial layer 30.

Then (Figure 3d), a second sacrificial layer 34, for example of silicon oxide with a thickness comprised for example between 0.5pm and 2um, is deposited on the first structural layer 31. The second sacrificial layer 34 at least partially fills the trenches 33.

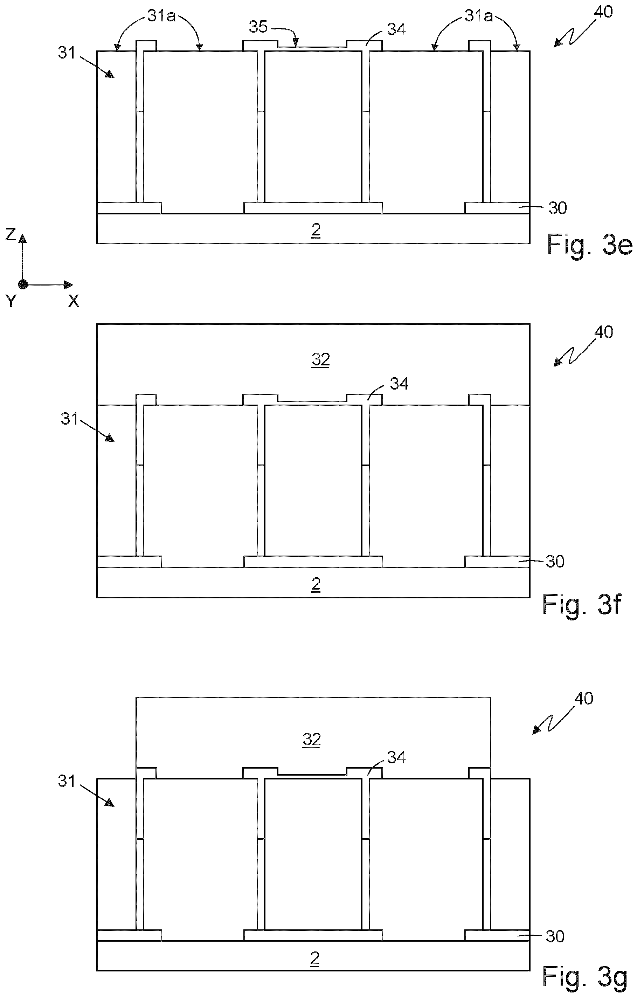

The second sacrificial layer 34 is thinned (Figure 3e) where it is desired that portions of the subsequent second structural layer 32 protrude downwards or are at a reduced distance from the first structural layer 31. For example, this processing is performed by time-etching with a dedicated mask (not shown), thus forming depressions 35 in the second sacrificial layer 34. The geometric characteristics (depth and amplitude) of the depression 35 of Figure 3e, which may be controlled in an accurate and reliable manner, determine the distance of the bump 7a of the connection element 7 from the stopping portion 4 of the movable mass 3 and the areas of the contact regions that delimit the allowed "out-of-plane" movements.

The second sacrificial layer 34 is instead completely removed at interface zones 31a where it is desired that the subsequent second structural layer 32 comes into contact with the first structural layer 31, in the MEMS device 1 for example in order to form respective structural connection regions between the anchor blocks 6 and the connection element 7. The second structural layer 32, also for example of silicon, is then formed (Figure 3f) above and in contact with the first structural layer 31 and with the second sacrificial layer 34. The thickness of the second structural layer 32 along the Z axis is comprised for example between 0.5pm and 2µm and determines the height along the Z axis of the connection element 7 of the stopping structure 5.

The second structural layer 32 is then patterned (Figure 3g), for example by a dry etching and up to the first structural layer 31, according to the desired upper microelectromechanical structures of the MEMS device 1, thus forming for example the connection element 7 of the stopping structure 5 of Figure 1. Finally, a selective removal, for example a hydrofluoric acid etching, allows the remaining portions of the second sacrificial layer 34 (above the first structural layer 31 and in the trenches 33) and the remaining portions of the first sacrificial layer 30 to be removed, thereby releasing the movable mass 3.

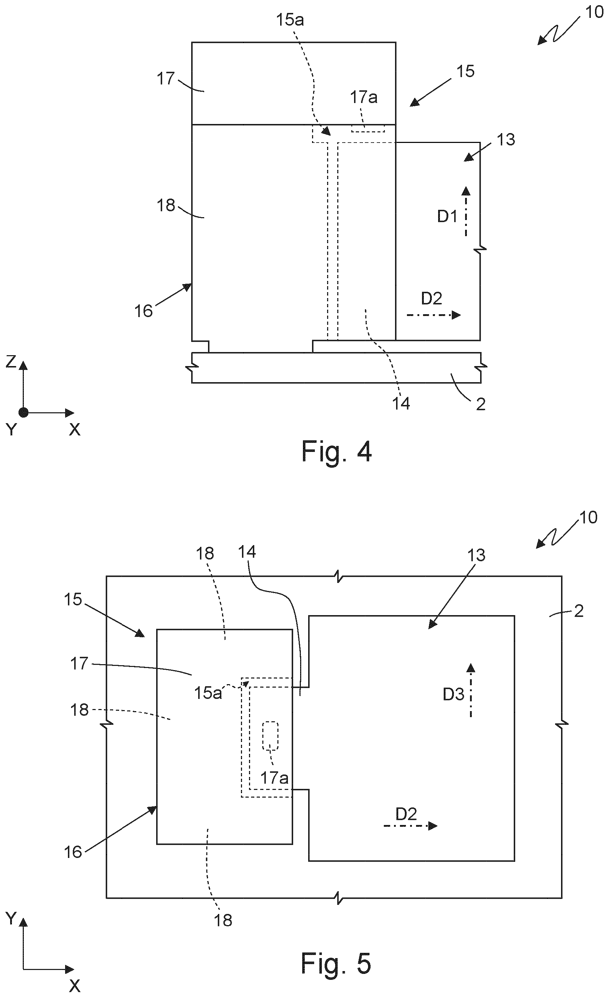

Figures 4 and 5 illustrate a portion of a MEMS device 10 in accordance with a different embodiment of the present invention, for example, an accelerometer sensor. Elements of Figures 4 and 5 which correspond to elements of Figures 1 and 2 are illustrated with the same reference numerals. Furthermore, the MEMS device 10 is described hereinbelow with reference to the differences with respect to the MEMS device 1.

The MEMS device 10 comprises a movable mass 13 coupled to the supporting body 2 so as to be capable of oscillating along the first, the second and the third motion directions D1, D2, D3. The MEMS device 10 further comprises a stopping structure 15, coupled to the supporting body 2 and configured to limit the movements of the movable mass 13 along the first, the second and the third motion directions D1, D2, D3 within respective safety intervals. In detail, the stopping structure 15 comprises an anchor block 16 which has a "C" configuration, in a top-plan view (Figure 5), and is defined by lateral elements 18. The stopping structure 15 further comprises a connection element 17 which connects the lateral elements 18 of the anchor block 16 to each other on a side opposite to the supporting body 2 and is in structural continuity with the same lateral elements 18.

The lateral elements 18 have a dimension in planes parallel to the XY plane and extend along the Z axis, starting from the supporting body 2, for a distance greater than the maximum height of the movable mass 13. More in detail, a first and a second lateral element 18 face each other and a third lateral element 18 connects corresponding ends thereof, extending transversely with respect to the first and the second and defining, as mentioned, a "C" configuration. The connection element 17 surmounts the anchor block 16 in contact. In particular, the connection element 17 of Figures 4 and 5 has a dimension in planes parallel to the XY plane such as to entirely overlay the anchor block 16.

This having been said, the lateral elements 18 and the connection element 17 delimit a cavity 15a that is blind on one side and open on the opposite side (parallel to the X axis). In other words, the stopping structure 15, and more in detail the anchor block 16, is internally hollow. According to what has been described hereinbelow, the stopping structure 15 of the MEMS device 10 may be referred to as a "cave"-type stopping structure.

A lateral region of the movable mass 13 of the MEMS device 10 has at least one protruding portion which hereinafter will be referred to as stopping portion 14 of the movable mass 13. In detail, the cavity 15a of the stopping structure 15 houses the stopping portion 14 of the movable mass 13. In other words, as shown in Figures 4 and 5, at least part of the stopping portion 14 is interposed between the supporting body 2 and the connection element 17 and is surrounded by the lateral elements 18.

The lateral elements 18 of the stopping structure 15 limit the movements of the movable mass 13 along the second and the third motion directions D2, D3, defining the respective safety intervals. The dimension (parallel to the XY plane) of the cavity 15a is a design parameter of the MEMS device 10 with respect to the "in-plane" stopping function to be implemented. For example, in Figure 5, the profile (in section) outlined by the lateral elements 18 of the stopping structure 15 is complementary to the profile of the stopping portion 14 of the movable mass 13.

The connection element 17 limits the movements of the movable mass 13 along the first motion direction D1, defining the respective safety interval. The distance of the connection element 17 from the stopping portion 14 of the movable mass 13, and therefore the height of the lateral elements 18 with respect to the supporting body 2, is a design parameter of the MEMS device 10 with respect to the "out-of-plane" stopping function to be implemented. For example, the connection element 17 of the stopping structure 15 of the MEMS device 10 may comprise a bump 17a protruding into the cavity 15a towards the stopping portion 14 of the movable mass 13 and having a shape selected as a function of the desired displacement limitation along the first motion direction D1.

The present embodiment of the stopping structure has the further advantage of a smaller area occupation per point of contact with the movable mass (the stopping structure is in fact a single block processed internally). Furthermore, the stopping structure may be placed along the external perimeter of the movable mass.

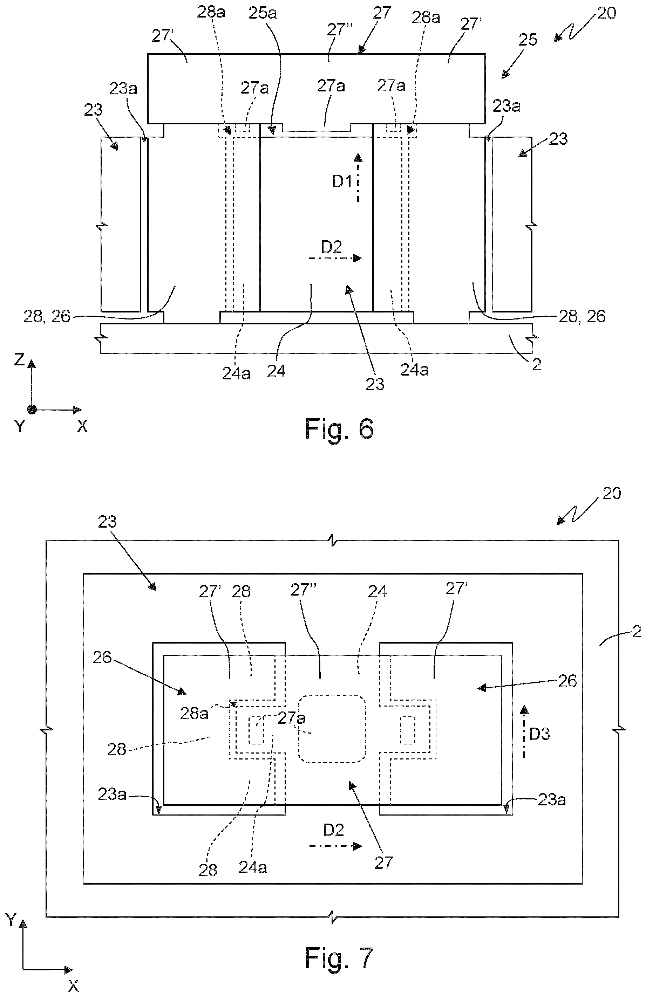

Figures 6 and 7 illustrate a portion of a MEMS device 20 in accordance with another embodiment of the present invention, for example, an accelerometer. Elements of Figures 6 and 7 which correspond to elements of Figures 1-5 are illustrated with the same reference numerals. Furthermore, the MEMS device 20 is described hereinbelow with reference to the differences with respect to the MEMS devices 1, 10.

The MEMS device 20 comprises a movable mass 23 coupled to the supporting body 2 so as to be capable of oscillating along the first, the second and the third motion directions D1, D2, D3. The MEMS device 20 further comprises a stopping structure 25, coupled to the supporting body 2 and configured to limit the movements of the movable mass 23 along the first, the second and the third motion directions D1, D2, D3 within respective safety intervals.

The stopping structure 25 is a combination of the "tunnel" and "cave" types previously described. In detail, the stopping structure 25 comprises a pair of anchor blocks 26 having a "C" configuration, in a top-plan view (Figure 7), and defined by respective lateral elements 28. The stopping structure 25 furthermore comprises a connection element 27 which bridge-connects the anchor blocks 26 to each other, being in structural continuity therewith.

More in detail, the lateral elements 28 of each anchor block 26 have a dimension in planes parallel to the XY plane and extend along the Z axis, starting from the supporting body 2, for a distance greater than the maximum height of the movable mass 23.

The connection element 27 extends substantially transversely to the pair of anchor blocks 26. The connection element 27 of the MEMS device 20 extends along the X axis connecting the lateral elements 28 of each anchor block 26 to each other and the anchor blocks to each other, surmounting them in contact. In particular, the connection element 27 of Figures 6 and 7 has a dimension in planes parallel to the XY plane such as to entirely overlay the anchor blocks 26 of the respective pair. First portions 27' refers to the two portions of connection element 27 which each overlay a respective anchor block 26 of the pair. Second portion 27" also refers to the portion of connection element 27 which connects the respective first portions 27'.

This having been said, in each anchor block 26, the lateral elements 28 and the respective first portion 27' of the connection element 27 delimit a first cavity 28a that is blind on one side and open on the opposite side (parallel to the X axis). In other words, each anchor block 26 of the stopping structure 25 is internally hollow.

The movable mass 23 of the MEMS device 20 has a pair of through openings 23a (parallel to the Z axis) which have a same dimension "in-plane", i.e. parallel to the XY plane (Figure 7). The movable mass 23 further comprises a stopping portion 24 interposed between the openings 23a of a respective pair. Each opening 23a of the movable mass 23 accommodates a respective anchor block 26 of the stopping structure 25. The lateral elements 28 of each anchor block 26 are therefore defined inside a respective opening 23a of the movable mass 23. Furthermore, the anchor blocks 26 of the respective pair are separated by the stopping portion 24.

The stopping portion 24 of the movable mass 23 has protruding portions 24a which extend in opposite directions each towards a respective anchor block 26. In detail, each first cavity 28a of each anchor block 26 houses a respective protruding portion 24a of the stopping portion 24. In other words, as shown in Figures 6 and 7, each protruding portion 24a of the stopping portion 24 lies between the supporting body 2 and a respective first portion 27' of the connection element 27 and is surrounded by the lateral elements 28 of the respective anchor block 26. Furthermore, the profiles of the openings 23a of the movable mass 23 follow the profile, in section, of the stopping portion 24.

The lateral elements 28 of each anchor block 26 of the stopping structure 25 limit the movements of the movable mass 23 along the second and the third motion directions D2, D3, defining the respective safety intervals. The dimension (parallel to the XY plane) of the first cavity 28a of each anchor block 26 is a design parameter of the MEMS device 20 with respect to the "in-plane" stopping function to be implemented. For example, in Figure 7, the profile (in section) outlined by the lateral elements 28 of each anchor block 26 is complementary to the profile of the protruding portion 24a of the stopping portion 24 of the movable mass 23.

The pair of anchor blocks 26 and the second portion 27" of the connection element 27 delimit a second through cavity 25a (parallel to the Y axis). The second cavity 25a of the stopping structure 25 is engaged by the stopping portion 24 of the movable mass 23. In other words, as shown in Figures 6 and 7, the stopping portion 24 lies between the supporting body 2 and the connection element 27, and, more in detail, the respective second portion 27". The second cavity 25a and the first cavities 28a of the pair of anchor blocks 26 are communicating with each other.

The connection element 27 limits the movements of the movable mass 23 along the first motion direction D1, defining the respective safety interval. The distance of the connection element 27 from the stopping portion 24 of the movable mass 23, and therefore the height of the lateral elements 28 of each anchor block 26 with respect to the supporting body 2, is a design parameter of the MEMS device 20 with respect to the "out-of-plane" stopping function to be implemented. For example, the connection element 27 of the stopping structure 25 of the MEMS device 20 comprises a plurality of bumps 27a which are portions of the connection element 27 protruding into the second cavity 25a and/or into the respective first cavities 28a of each anchor block 26, having a shape selected as a function of the desired displacement limitation along the first motion direction D1.

Finally, it is clear that modifications and variations may be made to what has been described and illustrated herein without thereby departing from the scope of the present invention, as defined in the attached claims.

For example, the MEMS devices described above may have a plurality of respective stopping structures which may be of the same type ("tunnel"-type or "cave"-type) as each other or may be different from each other according to the different embodiments described. The respective movable mass is therefore patterned according to what has been described so as to be capable of being coupled with this plurality of stopping structures.

In a variant not illustrated, the connection element of the stopping structure has dimensions on planes parallel to the XY plane such as to at least partially overlay the respective anchor blocks. For example, the connection element may have a dimension along the Y-axis that is smaller than the respective dimension along the Y-axis of the anchor blocks.

## Claims

1. A microelectromechanical device (1; 10; 20) comprising:
- a supporting body (2), containing semiconductor material;
- a movable mass (3; 13; 23), constrained to the supporting body (2) with a relative degree of freedom with respect to a first motion direction (D1) perpendicular to the supporting body (2); and
- at least one stopping structure (5; 15; 25), configured to limit out-of-plane movements of the movable mass (3; 13; 23) along the first motion direction (D1), wherein the stopping structure (5; 15; 25) comprises:
- first elements (6; 18; 26), extending parallel to the first motion direction (D1) and anchoring the stopping structure (5; 15; 25) to the supporting body (2); and
- a second element (7; 17; 27), extending transversely to the first elements (6; 18; 26), surmounting and connecting the first elements (6; 18; 26).

2. The device (1; 10; 20) according to claim 1, wherein the movable mass (3; 13; 23) comprises a stopping portion (4; 14; 24, 24a),
wherein the first elements (6; 18; 26) and the second element (7; 17; 27) of the stopping structure (5; 15; 25) delimit a cavity (5a; 15a; 25a, 28a),
wherein the stopping portion (4; 14; 24, 24a) of the movable mass (3; 13; 23) engages the cavity (5a; 15a; 25a, 28a),
and wherein the second element (7; 17; 27) delimits the cavity (5a; 15a; 25a, 28a) on one side opposite to the supporting body (2) and overlies the stopping portion (4; 14; 24, 24a) of the movable mass (3; 13; 23).

3. The device (1; 20) according to claim 2, wherein the cavity (5a; 25a) is a through cavity and wherein the stopping portion (4; 24) of the movable mass (3; 23) is arranged through the cavity (5a; 25a).

4. The device (1; 20) according to claim 2 or 3, wherein the movable mass (3; 23) has through openings (3a; 23a), parallel to the first motion direction (D1),
and wherein the first elements (6; 26) of the stopping structure (5; 25) comprise anchor blocks each extending through a respective opening (3a; 23a) of the movable mass (3; 23), the stopping portion (4; 24, 24a) of the movable mass (3; 23) being interposed between the first elements (6; 26) .

5. The device (20) according to the preceding claim, wherein the stopping portion (24) of the movable mass (23) comprises, on opposite sides, respective protruding portions (24a),
and wherein the second element (27) of the stopping structure (25) comprises a pair of first portions (27'), each first portion (27') surmounting a respective first element (26) of the stopping structure (25), and a second portion (27") which connects the respective first portions (27').

6. The device (20) according to the preceding claim, wherein each first element (26) of the stopping structure (25) is shaped so as to delimit, together with the respective first portion (27') of the second element (27), a respective further cavity (28a),
wherein each further cavity (28a) communicates with the cavity (25a) of the stopping structure (25),
and wherein the protruding portions (24a) of the stopping portion (24) of the movable mass (23) each engage a respective further cavity (28a).

7. The device (20) according to the preceding claim, wherein each first portion (27') of the second element (27) of the stopping structure (25) overlies a respective protruding portion (24a) of the stopping portion (24) of the movable mass (23).

8. The device (10) according to claim 2, wherein the stopping portion (14) comprises a protruding portion of the movable mass (13),
wherein the first elements (18) of the stopping structure (15) form an anchor block (16) partially delimiting the cavity (15a),
and wherein the cavity (15a) is blind on one side and open on the opposite side to be accessible by the stopping portion (14) of the movable mass (13).

9. The device (1; 10; 20) according to any of claims 2 to 8, wherein the second element (7; 17; 27) of the stopping structure (5; 15; 25) comprises a bump (7a; 17a; 27a) protruding into the cavity (5a; 15a; 25a, 28a).

10. The device (1; 10; 20) according to any of the preceding claims, wherein the movable mass (3; 13; 23) is further constrained to the supporting body (2) with a relative degree of freedom with respect to at least one of a second motion direction (D2) and a third motion direction (D3), the second and the third motion directions (D2, D3) being orthogonal to each other and both transversal to the first motion direction (D1),
and wherein the first elements (6; 18; 26) of the stopping structure (5; 15; 25) are configured to limit the movements of the movable mass (3; 13; 23) along at least one of the second motion direction (D2) and the third motion direction (D3).

11. The device (20) according to claim 10 when dependent on claim 6 or 7, wherein each first element (26) of the stopping structure (25) surrounds a respective protruding portion (24a) of the stopping portion (24) of the movable mass (23) .

12. The device (10) according to claim 10 when dependent on claim 8, wherein the first elements (18) of the stopping structure (15) surround the stopping portion (14) of the movable mass (13).

13. The device (1; 10; 20) according to any of the preceding claims, wherein the first elements (6; 18; 26) and the second element (7; 17; 27) form a body entirely of semiconductor material, and wherein the second element (7; 17; 27) is directly in contact with the first elements (6; 18; 26).

14. The device (1; 10; 20) according to any of the preceding claims, wherein the first elements (6; 18; 26) are obtained from an epitaxial first structural layer (31) and wherein the second element (7; 17; 27) is obtained from an epitaxial second structural layer (32), the second structural layer (32) being grown on the first structural layer (31).

15. Fabrication process of a microelectromechanical device (1; 10; 20) comprising:
- forming a first structural layer (31) of semiconductor material on a supporting body (2), containing semiconductor material;
- from the first structural layer (31), forming a movable mass (3; 13; 23), constrained to the supporting body (2) so that it has, in use, a relative degree of freedom with respect to a first motion direction (D1) perpendicular to the supporting body (2), and first elements (6; 18; 26), extending parallel to the first motion direction (D1) and anchored to the supporting body (2);
- forming a second structural layer (32) of semiconductor material on the first structural layer (31), directly in contact with the first elements (6; 18; 26) and at a distance from the movable mass (3; 13; 23); and
- from the second structural layer (32), form a second element (7; 17; 27) extending transversely to the first elements (6; 18; 26), in contact with the first elements (6; 18; 26) and above at and at a distance from a portion of the movable mass (3; 13; 23), so that the first elements (6; 18; 26) and the second element (7; 17; 27) define a stopping structure (5; 15; 25) configured to limit out-of-plane movements of the movable mass (3; 13; 23) along the first motion direction (D1).
